# FASCICULE DE BREVET EUROPEEN

(11) **EP 2 725 713 B1**
(45) Date de publication et mention de la délivrance du brevet: **30.12.2020**
(21) Numéro de dépôt: 13189123.6
(22) Date de dépôt: 17.10.2013
(51) Int. Cl.: H03G 3/30, H03D 1/18, H03K 5/007, H04L 27/08, H03K 9/00, H03K 9/02, H03D 1/10

(54) **SYSTÈME RÉCEPTEUR AMELIORÉ**
VERBESSERTES EMPFÄNGERSYSTEM
IMPROVED RECEIVER SYSTEM

(30) Priorité: 26.10.2012 EP 12190222
(43) Date de publication de la demande: 30.04.2014
(73) Titulaire: EM Microelectronic-Marin SA, 2074 Marin (CH)
(72) Inventeur: Tajalli, Armin, 1022 Chavannes-près-Renens (CH)
(74) Mandataire: Goulette, Ludivine

(56) Documents cités:
- EP-A1- 0 781 011
- EP-A2- 1 199 799
- CN-A- 102 185 646
- GB-A- 2 203 908
- JP-A- 2001 292 183
- US-A1- 2009 247 100

## Description

L'invention appartient au domaine des systèmes et/ou circuits récepteurs comprenant une borne d'entrée par laquelle un signal d'entrée est reçu, ledit circuit récepteur comprenant en outre :
- un premier étage amplificateur connecté par son entrée à la borne d'entrée dudit circuit récepteur ;
- un étage détecteur d'enveloppe consistant à détecter les maximas du signal reçu de façon à restituer son enveloppe, ledit étage détecteur étant connecté à la sortie du premier étage.

### ARRIERE PLAN TECHNOLOGIQUE

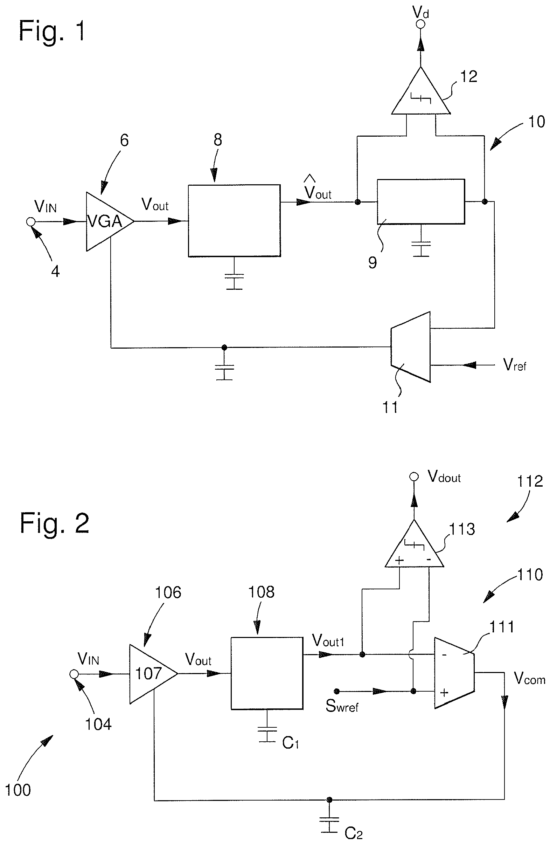

Il est connu que les appareils comme les téléphones mobiles ou satellites ou objets portables divers sont munis de circuits émetteur-récepteur comprenant une boucle d'émission servant à émettre un signal et une boucle de réception servant à recevoir un signal. Certain appareils comme les radio tuner ne sont équipés que d'un circuit électronique récepteur c'est-à-dire présentant une boucle réceptrice comme visible à la figure 1.

Une boucle de réception 10 comprend une borne d'entrée 4 par laquelle un signal d'entrée est reçu, ledit circuit récepteur comprenant en outre :
- un premier étage amplificateur 6 connecté par son entrée à la borne d'entrée dudit circuit récepteur ;
- un étage détecteur d'enveloppe 8 consistant à détecter les maximas du signal reçu de façon à restituer son enveloppe, ledit étage détecteur étant connecté à la sortie du premier étage.
- une étage détecteur de crête 9 utilisé pour détecter la valeur crête du signal et ajuster le gain. Cet étage détecteur de crête est aussi utilisé pour comparer les niveaux de l'étage détecteur d'enveloppe.
- un étage comparateur 12 connecté entre la sortie de l'étage détecteur d'enveloppe et la sortie de l'étage détecteur de crête. Cet étage comparateur est doté d'un module à hystérésis. Cet étage est utilisé pour fournir un signal de sortie de circuit récepteur soit un signal en créneau.

La boucle de réception est également munie d'un amplificateur différentiel 11 dont l'entrée négative est connectée en sortie de l'étage détecteur de crête, l'entrée positive permettant qu'un signal de référence puisse être comparé à la sortie de l'étage détecteur de crête. Cet amplificateur différentiel fourni un signal connecté au premier étage amplificateur afin d'agir sur lui et de modifier son gain.

Un inconvénient de ce circuit est que l'étage détecteur d'enveloppe, l'étage détecteur de crête et la piste de connexion entre la sortie de l'amplificateur différentiel et le premier étage amplificateur sont équipés de condensateurs de forte valeur. Or, ces condensateurs de forte valeur ont pour premier inconvénient d'être chers. Effectivement, les condensateurs de forte valeur, c'est-à-dire les condensateurs dont la valeur atteint ou dépasse le microfarad sont réalisés dans des technologies coûteuses et leur multiplication augmente ainsi le coût du circuit.

De plus, ces condensateurs ont une taille, en général, plus importante ce qui entraîne une plaque de circuit imprimé d'une surface plus grande et donc un coût qui augmente également.

Enfin, un autre inconvénient de ces condensateurs est qu'il est possible que des perturbations apparaissent. Ces perturbations se présentent sous la forme d'oscillation du signal. La conséquence est que le circuit ne fonctionne donc pas de manière optimale. Or, plus le nombre de condensateurs augmente et plus le risque d'oscillation augmente.

Enfin ce circuit récepteur a pour inconvénient d'être complexe car l'association d'un étage détecteur d'enveloppe et d'un étage détecteur de crête n'est pas simple.

La demande de brevet EP 0 781 011 A1 décrit un circuit détecteur de remise en forme d'un signal numérique à modulation d'amplitude. Il comprend un multiplicateur recevant le signal d'entrée, un détecteur de crêtes, un filtre passe-bas et un comparateur pour comparer le signal de sortie du filtre passe-bas avec une tension de référence pour fournir un signal démodulé. Une boucle d'adaptation automatique du gain comprend encore un amplificateur d'erreur recevant le signal de sortie du filtre passe-bas et la tension de référence pour fournir un signal de commande au multiplicateur pour adapter le gain.

La demande de brevet EP 1 199 799 A2 décrit un circuit compensateur de signaux et un circuit démodulateur d'un circuit récepteur. Il comprend un circuit détecteur, un premier étage amplificateur et un second étage amplificateur. Le second étage amplificateur compare le signal de sortie du premier étage amplificateur à un signal de référence. Le circuit récepteur comprend encore un étage de production de signaux pour détecter des variations de signaux.

La demande de brevet JP 2001-292183 décrit un circuit pour démoduler un signal de données à modulation d'amplitude. Il est prévu pour fournir un signal de sortie à un comparateur à hystérèse.

### RESUME DE L'INVENTION

L'invention a pour but de pallier les inconvénients de l'art antérieur en proposant de fournir un système récepteur meilleur marché avec une fiabilité et une stabilité améliorée.

A cet effet, l'invention concerne un circuit récepteur comprenant les caractéristiques de la revendication indépendante 1.

Un avantage de ce circuit récepteur est de limiter le nombre de composants puisque l'utilisation d'un détecteur de crête n'est pas nécessaire. De ce fait, le condensateur de forte valeur associé au circuit détecteur de crête n'est également pas utilisé. Cela permet de réaliser une économie de surface de circuit imprimé mais également une économie en termes de coût car ces composants représentent des dépenses non négligeables.

De plus, le fait de limiter le nombre de condensateurs de forte valeur permet d'avoir une meilleure sensibilité du circuit récepteur. Effectivement, les condensateurs de forte valeur sont connus pour entraîner l'apparition de perturbations qui détériore la sensibilité.

Dans un premier mode de réalisation avantageux, l'étage détecteur d'enveloppe comprend en outre une capacité de protection.

Le circuit comparateur comprend un bloc comparateur faisant la différence entre le signal de sortie de l'étage détecteur d'enveloppe et le signal de sortie du second étage amplificateur, et un bloc hystérésis.

Dans un autre mode de réalisation avantageux, le bloc hystérésis comprend deux paires de transistors du même type comprenant chacune un premier transistor et un second transistor, les transistors d'une même paire étant connectés à la masse, la grille du premier transistor de la première paire et la grille du second transistor de la seconde paire étant connectées ensembles de sorte à former un premier point de connexion alors que la grille du second transistor de la première paire et la grille du premier transistor de la seconde paire sont connectées ensembles de sorte à former un second point de connexion, ledit bloc hystérésis étant en outre agencé de sorte que les drains du premier transistor de la première paire et du second transistor à former un second point de connexion, ledit bloc hystérésis étant en outre agencé de sorte que les drains du premier transistor de la première paire et du second transistor de la second paire soient connectés au bloc comparateur, les drains du second transistor de la première paire et du premier transistor de la second paire étant respectivement connectés au drain du second transistor de la second paire et au drain du premier transistor de la première paire.

Dans un autre mode de réalisation avantageux, le bloc hystérésis comprend en outre une partie programmable comprenant deux transistors de programmation connectés chacun par son drain à aux sources des transistors d'une des deux paires de transistors du bloc hystérésis, les sources de ces transistors de programmation étant connectées à la masse et en ce que la grille de chaque transistor forment un point de connexion pour un signal de programmation.

Le bloc comparateur (BC) est connecté à la masse via un premier transistor de réglage traversé par un premier courant de réglage, le bloc hystérésis étant connecté à la masse via un second transistor de réglage traversé par un second courant de réglage, la largueur de l'hystérésis étant lié au rapport entre le second courant de réglage et le premier courant de réglage.

Dans un autre mode de réalisation avantageux, le premier transistor de réglage et le second transistor de réglage sont chacun constitués d'une multitude de transistor en parallèle pouvant être chacun sélectivement activé ou désactivé et en ce que le rapport entre le second courant de réglage et le premier courant de réglage est réglé en modifiant le nombre de transistors activés pour le premier transistor de réglage et pour le second transistor de réglage.
Dans un autre mode de réalisation avantageux, le bloc comparateur fait la différence entre le signal de sortie de l'étage détecteur d'enveloppe et le signal de référence, cette différence consistant à faire la moyenne du signal détecté et à comparer cette moyenne avec la valeur du signal de référence.

### BREVE DESCRIPTION DES FIGURES

Les buts, avantages et caractéristiques du système récepteur selon la présente invention apparaîtront plus clairement dans la description détaillée suivante d'au moins une forme de réalisation de l'invention donnée uniquement à titre d'exemple non limitatif et illustrée par les dessins annexés sur lesquels :
- La figure 1 représente schématiquement un système récepteur selon l'art antérieur;
- La figure 2 représente schématiquement un système récepteur selon l'invention; et
- La figure 3 représente schématiquement l'étage comparateur du système récepteur selon l'invention.

### DESCRIPTION DETAILLEE

Sur la figure 2, un circuit ou système récepteur 100 selon la présente invention est représenté. Ce circuit récepteur 100 comprend une entrée 104 par laquelle un signal est reçu. Ce signal Vin est un signal contenant une information pouvant être aussi bien un signal haute fréquence qu'un signal basse fréquence. Ce signal Vin se présente sous la forme d'un signal modulé en amplitude.

Cette entrée 104 est connectée à une première entrée d'un premier étage amplificateur 106. Ce premier étage comparateur 106 comprend un amplificateur à faible bruit 107. Cet amplificateur à faible bruit 107 a pour but d'amplifier le signal reçu pour fournir un signal d'entrée amplifié Vout.

La sortie du premier étage amplificateur 106 est connectée à un étage détecteur d'enveloppe 108. Cet étage détecteur d'enveloppe 108 est utilisé afin de démoduler le signal d'entrée amplifié Vout qui est le signal Vin reçu amplifié c'est à dire fournir un signal détecté Vout1 épousant les contours du signal d'entrée amplifié. Cet étage détecteur d'enveloppe 108 est également utilisé pour extraire des informations sur l'amplitude du signal d'entrée amplifié Vout. Cet étage 108 comprend en outre un condensateur C1 de forte capacité reliant ledit étage détecteur d'enveloppe à la masse. Ce condensateur C1 est utilisé pour la détection d'enveloppe et pour le filtrage des signaux hautes fréquences.

Avantageusement selon l'invention, la sortie de cet étage détecteur d'enveloppe 108 est connectée à un second étage amplificateur 110 pouvant aussi être appelé second étage comparateur. Ce second étage amplificateur 110 comprend un amplificateur opérationnel à transconductance 111. Le signal détecté Vout1 de l'étage détecteur d'enveloppe 108 est connectée à l'entrée négative dudit amplificateur opérationnel à transconductance 111. L'entrée positive dudit amplificateur opérationnel à transconductance 111 est utilisée pour qu'un signal de référence Vswref puisse y être connecté. Ce signal de référence Vswref se présente sous la forme d'un signal continu dont la valeur de tension est prédéterminée.

L'amplificateur opérationnel à transconductance 111 est utilisé pour fournir, en sortie, un signal de commande Vcom servant de consigne. Ce signal de commande Vcom est connecté à une seconde entrée du premier étage amplificateur 106 c'est-à-dire à une second entrée de l'amplificateur à faible bruit 107. Ce signal de commande Vcom a pour but d'agir sur le l'amplificateur à faible bruit 107 afin de modifier son gain de sorte que la démodulation soit optimale.

Pour fournir le signal de commande Vcom, l'amplificateur opérationnel à transconductance 111 compare le signal Vout1 avec un signal de référence Vswref. Le signal Vout1 est transformé par l'amplificateur opérationnel à transconductance 111. En théorie, l'amplificateur opérationnel à transconductance 111 est configuré pour superposer le signal détecté Vout1 en sortie de l'étage détecteur d'enveloppe 108 et le signal de référence Vswref et calculer l'aire du signal Vout1 se situant au-dessus de Vswref et au-dessous de Vswref. Une fois ces aires calculées par intégration, elles sont comparées entre elles. En pratique, ce calcul consiste à faire la moyenne du signal détecté Vout1 et à comparer cette moyenne avec la valeur du signal Vswref idéalement, la valeur moyenne du signal détecté Vout1 doit être égale à la valeur du signal Vswref.

Ainsi, si le signal Vout1 de sortie de l'étage détecteur d'enveloppe 108 présente une valeur moyenne inférieure à la valeur moyenne du signal de référence Vswref, alors le signal de commande Vcom envoyé a pour but d'augmenter le gain du premier étage amplificateur 106. Au contraire, si le signal détecté Vout1 de sortie de l'étage détecteur d'enveloppe 108 présente une valeur moyenne supérieure à la valeur moyenne du signal de référence Vswref, alors le signal Vcom envoyé a pour but de diminuer le gain dudit premier étage amplificateur 106. Par contre, si le signal détecté Vout1 de sortie de l'étage détecteur d'enveloppe 108 présente une valeur moyenne égale à la valeur moyenne du signal de référence Vswref alors le gain n'est pas modifié.

Cela permet de garder le signal détecté Vout1 dans un intervalle d'amplitude. De ce fait, l'ajustement du gain du premier étage amplificateur 106 se fait uniquement avec le détecteur d'enveloppe 108 et l'amplificateur opérationnel à transductance 111. On a donc le circuit détecteur de crête qui n'est plus utilisé et on obtient un circuit plus compact, moins coûteux. De plus, on utilise un condensateur de moins ce qui accroit la stabilité du système.

L'amplificateur opérationnel à transconductance 111 comprend en outre une capacité C2 de forte valeur connectée en parallèle de la sortie dudit amplificateur opérationnel à transconductance 111. Cette capacité est connectée avec la masse et est utilisée comme intégrateur pour stabiliser la boucle réceptrice. L'erreur est stockée au niveau du condensateur C2 et la boucle de contrôle du gain fait un réglage à la valeur désirée uniquement lorsque l'erreur est nulle ce qui implique que le condensateur C2 ne sera pas chargé ou déchargé.

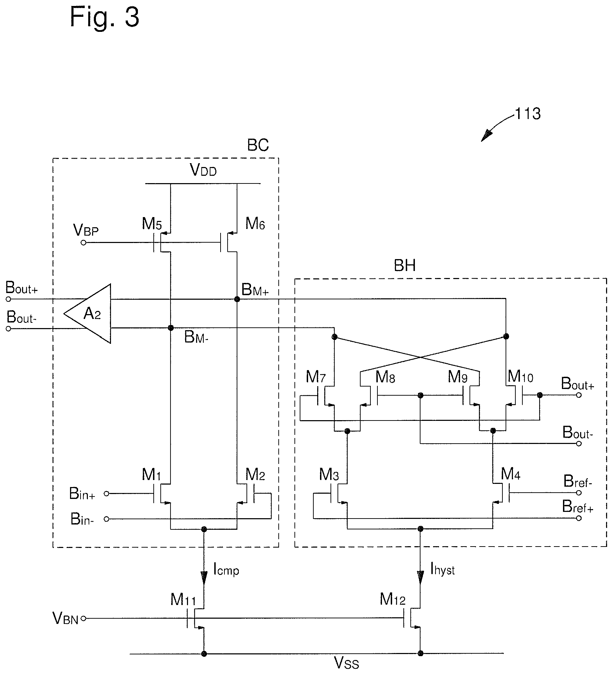

De plus, le circuit récepteur 100 comprend en outre un étage comparateur 112. Cet étage comparateur 112, visible à la figure 3, fournit le signal de sortie du système Vdout et comprend un circuit comparateur glisseur 113 qui comprend un bloc comparateur BC ainsi qu'un bloc hystérésis BH et est alimenté par une tension Vdd, la masse étant appelée Vss.

Le bloc comparateur BC est le bloc par lequel l'entrée et la sortie de l'étage comparateur 112 sont agencées. L'entrée dudit étage comparateur 112 est formée par deux bornes d'entrées Bin+ et Bin- comprenant une paire de transistors de type N appelé M1 et M2. La borne Bin+ est connectée au transistor M1 et la borne Bin- est connectée au transistor M2.

Dans le cas présente, la borne Bin+ est connectée à la sortie du circuit détecteur d'enveloppe 108 alors que la borne Bin- est connectée à la borne d'entrée positive de l'amplificateur opérationnel à transconductance 111 c'est-à-dire au signal de référence Swref. Les grilles de ces transistors M1 et M2 forment les bornes d'entrée de l'étage comparateur 112. Le bloc comparateur BC comprend en outre une paire de transistor de type P appelés M5 et M6. Le drain du transistor M5 est connecté au drain du transistor M1 alors que le drain du transistor M6 est connecté au drain du transistor M2. La source des transistors M5 et M6 est connectée à la tension Vdd alors que les grilles de ces transistors M5 et M6 sont connectées ensembles pour former un point de connexion permettant d'appliquer un signal pour activer les transistors de type P.

Entre les drains de M1 et M5 et les drains de M2 et M6, deux points de connexions de sorties Bm+ et Bm- sont agencés. Ces points de connections Bm+ et Bm- entrent dans un circuit A2 qui amplifie le gain de l'étage comparateur 112 afin d'obtenir deux bornes de sorties Bout+ et Bout- de l'étage comparateur 112. Les bornes de sorties Bout+ et Bout-permettent de fournir en sortie le signal de sortie Vdout.

La source du transistor M1 et la source du transistor M2 sont connectées ensembles au drain d'un premier transistor de réglage de type N appelé M11, ce dernier ayant sa source connectée à la masse Vss, un premier courant de réglage Icmp traversant ledit transistor M11.

Le bloc hystérésis BH comprend une première partie composée de deux paires de transistors M7, M8 et M9, M10. Chaque paire de transistors comprend deux transistors de type N. On comprendra que les transistors M7, M8 forment une première paire alors que les transistors M9, M10 forment une seconde paire. Les transistors de chaque paire ont leurs sources connectées ensembles et également connectées au drain du transistor M12.

Cette première partie du bloc hystérésis BH est en outre agencée pour être connectée respectivement, au point de connexion Bm- c'est-à-dire la connexion entre le drain de M1 et le drain et M5 et au point de connexion Bm+ c'est-à-dire la connexion entre le drain de M2 et le drain et M6. Pour cela, le drain du transistor M7 et le drain du transistor M10 sont respectivement connectés respectivement, au point de connexion Bm- et au point de connexion Bm+. Les drains des transistors M8 et M9 sont connectés afin que le drain de M8 soit connecté au drain de M10 et que le drain de M9 soit connecté au drain de M7.

Par ailleurs, les grilles des transistors sont reliées deux à deux de sortes que la grilles des transistors M7 et M10 sont reliées ensembles et les grilles des transistors M8 et M9 sont reliées ensembles. Cet agencement permet de former deux points de connexions qui sont connectés au sorties Bout+ et Bout- de l'étape comparateur 112.

La configuration de la première partie du bloc hystérésis BH permet d'obtenir une fonction hystérésis associée au bloc comparateur BC. On obtient alors un circuit classique de comparateur muni d'une fonction hystérésis. Le fonctionnement de ce circuit consiste, dans le bloc comparateur BC, à faire la comparaison entre le signal détecté Vout1 et le signal de référence Vswref. A cela, le bloc hystérésis BH est utilisé pour compléter cette comparaison en prenant en compte la sortie dudit étage comparateur 112 ainsi que le signal d'hystérésis

Dans une variante avantageuse, le bloc hystérésis comprend une seconde partie programmable. Cette seconde partie comprend une paire de transistor de type N appelée M3 et M4 dont les sources sont reliées ensembles. Les drains des transistors M3 et M4 sont connectés à une seconde partie. Par conséquent, la source du transistor M7 est connectée à la source du transistor M8 et au drain du transistor M3 alors que la source du transistor M9 est connectée à la source du transistor M10 et au drain du transistor M4. Les sources des transistors M3 et M4 sont connectées au drain d'un second transistor de réglage M12, dont la source est reliée à la masse Vss, la grille de ce transistor M12 étant reliée à la grille du transistor M11, un second courant de réglage Ihyst traversant ledit transistor M12. Cette configuration permet aux transistors M11 et M12 de former un point de connexion permettant d'appliquer un signal pour activer les transistors de type N. Les grilles des transistors M3 et M4 forment chacune une borne de connexion, respectivement Bref+ et Bref-, utilisée pour modifier l'hystérésis.

En effet, la largeur de l'hystérésis de ce circuit est dépendante du rapport entre le courant Ihyst lié à M12 et le courant Icmp lié à M11. Cette largeur de l'hystérésis peut alors être contrôlée en modifiant ce rapport Ihyst/Icmp. Pour cela, il est à considérer que les transistors M11 et M12 sont chacun constitués en réalité d'une multitude de transistors en parallèle. Cette configuration permet au courant d'être réparti dans les différents transistors. Idéalement, les transistors M11 et M12 sont chacun constitués du même nombre de transistors en parallèle. Quand tous les transistors pour M11 et M12 sont fermés, on obtient un rapport entre Ihyst et Icmp. Pour modifier ce rapport, il suffit de modifier le nombre de transistors qui sont fermés. Cela entraîne une augmentation du courant circulant dans chaque transistor. De ce fait, le rapport entre le courant Ihyst et le courant Icmp varie. Par exemple, on suppose que M11 et M12 comprennent chacun vingt transistors en parallèle de sorte que l'on ait Ihyst = Icmp. Si le nombre de transistors M12 diminue à 10 alors que le nombre de transistors M11 reste constant à 20, on obtient alors Ihyst = 0.5 Icmp et donc une largeur d'hystérésis modifiée. Il est, par conséquent, facile de modifier la largeur de l'hystérésis en commutant plus ou moins de transistors.

Il est également possible de modifier la largeur de l'hystérésis en utilisant les bornes de connexion Bref+ et Bref-. Le signal envoyé dans chacune de ces bornes de connexion Bref+ et Bref- permet de modifier le courant Ihyst et donc de modifier la largeur de l'hystérésis comme visible à la figure 3. Plus précisément, en augmentant la tension appliquée au point de connexion Bref+, on augmente la largeur de l'hystérèse c'est-à-dire qu'on retarde la commutation pour passer d'un niveau bas à un niveau haut et la commutation pour passer d'un niveau haut à un niveau bas. Inversement en diminuant la largeur de l'hystérèse, les commutations sont plus rapprochées. Or, cet hystérésis permet de diminuer les effets du bruit sur les signaux. Par conséquent, cette capacité de programmer la largeur de l'hystérèse permet d'adapter la réduction du bruit en fonction du signal reçu ou des composants utilisés.

Bien entendu, il est possible de régler la largeur de l'hystérésis avant la fabrication en adaptant, modifiant la taille des transistors M11 et M12.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention définie par les revendications annexées.

## Revendications

1. Circuit récepteur (100) comprenant une borne d'entrée par laquelle un signal d'entrée (Vin) est reçu, ledit circuit récepteur comprenant en outre :
- un premier étage amplificateur (106) connecté par une de ses entrées à la borne d'entrée (104) dudit circuit récepteur et fournissant un signal amplifié (Vout), ledit premier étage amplificateur comprenant un amplificateur à faible bruit (107),
- un étage détecteur d'enveloppe (108), connecté à la sortie du premier étage, consistant à détecter les maximas du signal reçu amplifié (Vout) de façon à restituer son enveloppe et fournir un signal détecté (Vout1),
- un circuit comparateur (112) ayant une entrée positive connectée à la sortie de l'étage détecteur d'enveloppe (108) et une entrée négative recevant un signal de référence (Swref) afin de comparer la sortie de l'étage détecteur d'enveloppe (Vout1) au signal de référence (Swref) et fournir un signal démodulé de sortie (Vdout),
- un second étage amplificateur (110) ayant une entrée négative connectée à la sortie de l'étage détecteur d'enveloppe (108) et une entrée positive recevant le signal de référence (Swref),
**caractérisé en ce que**
le second étage amplificateur (110) comprend un amplificateur opérationnel à transconductance (111) consistant à comparer le signal détecté (Vout1) en sortie de l'étage détecteur avec le signal de référence (Swref) pour fournir un signal de commande (Vcom) envoyé au premier étage amplificateur (106) permettant de faire varier le gain du premier étage amplificateur, et
**en ce que** le circuit comparateur (112) comprend un bloc comparateur (BC) faisant la différence entre le signal de sortie de l'étage détecteur d'enveloppe (Vou1t) et le signal de référence (Swref), et un bloc hystérésis (BH), ledit bloc comparateur (BC) étant connecté à la masse via un premier transistor de réglage (M11) traversé par un premier courant de réglage (Icmp), et **en ce que** le bloc hystérésis (BH) est connecté à la masse (Vss) via un second transistor de réglage (M12) traversé par un second courant de réglage (Ihyst), la largueur de l'hystérésis étant liée au rapport entre le second courant de réglage (Ihyst) et le premier courant de réglage (Icmp).

2. Circuit récepteur selon la revendication 1, **caractérisé en ce que** l'étage détecteur d'enveloppe comprend en outre un condensateur (C1) de détection d'enveloppe et de filtrage de signaux hautes fréquences.

3. Circuit récepteur selon la revendication 1, **caractérisé en ce que** le bloc hystérésis (BH) comprend deux paires de transistors (M7, M8 et M9, M10) du même type comprenant chacune un premier transistor (M7, M9) et un second transistor (M8, M10), deux transistors (M3, M4) d'une partie programmable étant connectés chacun par son drain aux sources des transistors d'une des deux paires de transistors du bloc hystérésis, les sources des transistors (M3, M4) de la partie programmable étant connectées ensembles au drain du second transistor de réglage (M12), la grille du premier transistor (M7) de la première paire et la grille du second transistor (M10) de la seconde paire étant connectées ensembles de sorte à former un premier point de connexion (Bout+) alors que la grille du second transistor (M9) de la première paire et la grille du premier transistor (M8) de la seconde paire sont connectées ensembles de sorte à former un second point de connexion (Bout-), ledit bloc hystérésis étant en outre agencé de sorte que les drains du premier transistor (M7) de la première paire et du second transistor (M10) de la second paire soient connectés au bloc comparateur (BC), les drains du second transistor de la première paire et du premier transistor de la second paire étant respectivement connectés au drain du second transistor de la second paire et au drain du premier transistor de la première paire.

4. Circuit récepteur selon la revendication 3, **caractérisé en ce que** la partie programmable comprenant deux transistors de programmation (M3, M4) connectés chacun par son drain aux sources des transistors d'une des deux paires de transistors du bloc hystérésis (BH), les sources de ces transistors de programmation étant connectées à la masse via le second transistor de réglage (M12), et **en ce que** les grilles de chaque transistor forment un point de connexion (Bref+, Bref-) pour un signal de programmation.

5. Circuit récepteur selon la revendication 1, **caractérisé en ce que** le premier transistor de réglage (M11) et le second transistor de réglage (M12) sont chacun constitués d'une multitude de transistors en parallèle pouvant être chacun sélectivement activé ou désactivé, et **en ce que** le rapport entre le second courant de réglage (Ihyst) et le premier courant de réglage (Icmp) est réglé en modifiant le nombre de transistors activés pour le premier transistor de réglage (M11) et pour le second transistor de réglage (M12) afin de modifier la largeur de l'hystérésis.

## Patentansprüche

1. Empfängerschaltung (100), die eine Eingangsklemme umfasst, über die ein Eingangssignal (Vin) empfangen wird, wobei die Empfängerschaltung weiter umfasst:
- eine erste Verstärkerstufe (106), die über einen ihrer Eingänge an die Eingangsklemme (104) der Empfängerschaltung angeschlossen ist und ein verstärktes Signal (Vout) liefert, wobei die erste Verstärkerstufe einen rauscharmen Verstärker (107) umfasst,
- eine an den Ausgang der ersten Stufe angeschlossene Hüllkurvendetektorstufe (108), die darin besteht, die Maxima des empfangenen verstärkten Signals (Vout) zu detektieren, um dessen Hüllkurve wiederherzustellen und ein detektiertes Signal (Vout1) zu liefern,
- eine Komparatorschaltung (112) mit einem positiven Eingang, der an den Ausgang der Hüllkurvendetektorstufe (108) angeschlossen ist, und einem negativen Eingang, der ein Referenzsignal (Swref) empfängt, um den Ausgang der Hüllkurvendetektorstufe (Vout1) mit dem Referenzsignal (Swref) zu vergleichen und ein demoduliertes Ausgangssignal (Vdout) zu liefern,
- eine zweite Verstärkerstufe (110) mit einem negativen Eingang, der an den Ausgang der Hüllkurvendetektorstufe (108) angeschlossen ist, und einem positiven Eingang, der das Referenzsignal (Swref) empfängt,
**dadurch gekennzeichnet, dass**
die zweite Verstärkerstufe (110) einen Transkonduktanz-Operationsverstärker (111) umfasst, der darin besteht, das am Ausgang der Detektorstufe detektierte Signal (Vout1) mit dem Referenzsignal (Swref) zu vergleichen, um ein Ansteuersignal (Vcom) zu liefern, das an die erste Verstärkerstufe (106) gesendet wird und es ermöglicht, die Verstärkung der ersten Verstärkerstufe zu variieren, und
dadurch, dass die Komparatorschaltung (112) einen Komparatorblock (BC), der die Differenz zwischen dem Ausgangssignal der Hüllkurvendetektorstufe (Vout1) und dem Referenzsignal (Swref) ermittelt, und einen Hystereseblock (BH) umfasst, wobei der Komparatorblock (BC) über einen ersten Stelltransistor (M11), der von einem ersten Einstellstrom (Icmp) durchflossen wird, an die Masse angeschlossen ist, und dadurch, dass der Hystereseblock (BH) über einen zweiten Stelltransistor (M12), der von einem zweiten Einstellstrom (Ihyst) durchflossen wird, an die Masse (Vss) angeschlossen ist, wobei die Breite der Hysterese mit dem Verhältnis zwischen dem zweiten Einstellstrom (Ihyst) und dem ersten Einstellstrom (Icmp) zusammenhängt.

2. Empfängerschaltung nach Anspruch 1, **dadurch gekennzeichnet, dass** die Hüllkurvendetektorstufe weiter einen Kondensator (C1) zur Hüllkurvendetektion und Filterung von Hochfrequenzsignalen umfasst.

3. Empfängerschaltung nach Anspruch 1, **dadurch gekennzeichnet, dass** der Hystereseblock (BH) zwei Transistorenpaare (M7, M8 und M9, M10) desselben Typs umfasst, die jedes einen ersten Transistor (M7, M9) und einen zweiten Transistor (M8, M10) umfassen, wobei zwei Transistoren (M3, M4) eines programmierbaren Teils jeweils über ihre Senke an die Quellen der Transistoren eines der zwei Transistorenpaare des Hystereseblocks angeschlossen sind, wobei die Quellen der Transistoren (M3, M4) des programmierbaren Teils an der Senke des zweiten Stelltransistors (M12) aneinander angeschlossen sind, wobei das Gate des ersten Transistors (M7) des ersten Paares und das Gate des zweiten Transistors (M10) des zweiten Paares so aneinander angeschlossen sind, dass ein erster Anschlusspunkt (Bout+) gebildet wird, während das Gate des zweiten Transistors (M9) des ersten Paares und das Gate des ersten Transistors (M8) des zweiten Paares so aneinander angeschlossen sind, dass ein zweiter Anschlusspunkt (Bout-) gebildet wird, wobei der Hystereseblock weiter so eingerichtet ist, dass die Senken des ersten Transistors (M7) des ersten Paares und des zweiten Transistors (M10) des zweiten Paares an den Komparatorblock (BC) angeschlossen sind, wobei die Senken des zweiten Transistors des ersten Paares und des ersten Transistors des zweiten Paares jeweils an die Senke des zweiten Transistors des zweiten Paares und an die Senke des ersten Transistors des ersten Paares angeschlossen sind.

4. Empfängerschaltung nach Anspruch 3, **dadurch gekennzeichnet, dass** der programmierbare Teil zwei Programmiertransistoren (M3, M4) umfasst, die jeweils über ihre Senke an die Quellen der Transistoren eines der zwei Transistorenpaare des Hytereseblocks (BH) angeschlossen sind, wobei die Quellen dieser Programmiertransistoren über den zweiten Stelltransistor (M12) an die Masse angeschlossen sind, und dadurch, dass die Gates jedes Transistors einen Anschlusspunkt (Bref+, Bref-) für ein Programmiersignal bilden.

5. Empfängerschaltung nach Anspruch 1, **dadurch gekennzeichnet, dass** der erste Stelltransistor (M11) und der zweite Stelltransistor (M12) jeweils aus einer Vielzahl von parallelen Transistoren bestehen, die jeweils selektiv aktiviert oder deaktiviert werden können, und dadurch, dass das Verhältnis zwischen dem zweiten Einstellstrom (Ihyst) und dem ersten Einstellstrom (Icmp) eingestellt wird, indem die Anzahl von aktivierten Transistoren beim ersten Stelltransistor (M11) und beim zweiten Stelltransistor (M12) verändert wird, um die Breite der Hysterese zu verändern.

## Claims

1. A receiver circuit (100) including an input terminal through which an input signal (Vin) is received, said receiver circuit further including:
- a first amplifier stage (106) connected via one of the inputs thereof to the input terminal (104) of said receiver circuit and delivering an amplified signal (Vout), said first amplifier stage including a low-noise amplifier (107),
- an envelope detector stage (108), connected to the first stage output, for detecting maxima in the amplified incoming signal (Vout) in order to recover the signal envelope and to deliver a detected signal (Vout1),
- a comparator circuit (112) having a positive input connected to the output of the envelope detector stage (108) and a negative input receiving a reference signal (Swref) in order to compare the output of the envelope detector stage (Vout1) to the reference signal (Swref) and to deliver a demodulated output signal (Vdout),
- a second amplifier stage (110) having a negative input connected to the output of the envelope detector stage (108) and a positive input receiving the reference signal (Swref),
**characterised in that**
the second amplifier stage (110) includes an operational transconductance amplifier (111) consisting in comparing the signal detected (Vout1) at the output of the detector stage to the reference signal (Swref) to deliver a control signal (Vcom) sent to the first amplifier stage (106) for varying the gain of the first amplifier stage, and
**in that** the comparator circuit (112) includes a comparator unit (BC) distinguishing between the output signal from the envelope detector stage (Vout1) and the reference signal (Swref), and a hysteresis unit (BH), said comparator unit (BC) being connected to earth via a first regulating transistor (M11) traversed by a first regulating current (Icmp), and **in that** the hysteresis unit (BH) is connected to earth (Vss) via a second regulating transistor (M12) traversed by a second regulating current (Ihyst), the hysteresis width being linked to the ratio between the second regulating current (Ihyst) and the first regulating current (Icmp).

2. The receiver circuit according to claim 1, **characterised in that** the envelope detector stage further includes a capacitor (C1) for envelope detection and for filtering high-frequency signals.

3. The receiver circuit according to claim 1, **characterised in that** the hysteresis unit (BH) includes two pairs of transistors (M7, M8 and M9, M10) of the same type each including a first transistor (M7, M9) and a second transistor (M8, M10), two transistors (M3, M4) of a programmable part each being connected via the drain thereof to the sources of the transistors of one of the two pairs of transistors of the hysteresis unit, the sources of the transistors (M3, M4) of the programmable part being connected together to the drain of the second regulating transistor (M12), the gate of the first transistor (M7) of the first pair and the gate of the second transistor (M10) of the second pair being connected to each other so as to form a first connection point (Bout+), whereas the gate of the second transistor (M9) of the first pair and the gate of the first transistor (M8) of the second pair are connected to each other so as to form a second connection point (Bout-), said hysteresis unit being further arranged so that the drains of the first transistor (M7) of the first pair and of the second transistor (M10) of the second pair are connected to the comparator unit (BC), the drains of the second transistor of the first pair and of the first transistor of the second pair being respectively connected to the drain of the second transistor of the second pair and to the drain of the first transistor of the first pair.

4. The receiver circuit according to claim 3, **characterised in that** the programmable part includes two programming transistors (M3, M4) each connected via the drain thereof to the sources of the transistors of one of the two pairs of transistors of the hysteresis unit (BH), the sources of these programming transistors being connected to earth via the second regulating transistor (M12), and **in that** the gates of each transistor form a connection point (Bref+, Bref-) for a programming signal.

5. The receiver circuit according to claim 1, **characterised in that** the first regulating transistor (M11) and the second regulating transistor (M12) are each formed of a multitude of transistors in parallel each able to be selectively activated or deactivated and **in that** the ratio between the second regulating current (Ihyst) and the first regulating current (Icmp) is regulated by modifying the number of transistors activated for the first regulating transistor (M11) and for the second regulating transistor (M12) in order to modify the hysteresis width.
